# EUROPEAN PATENT APPLICATION

(11) **EP 4 752 871 A1**
(43) Date of publication of application: **03.06.2026**
(21) Application number: 23946467.0
(22) Date of filing: 24.11.2023
(51) Int. Cl.: G09G 3/20

(54) **GATE DRIVING CIRCUIT AND DISPLAY PANEL**

(30) Priority: 24.07.2023 CN 202310922942
(71) Applicant: Wuhan China Star Optoelectronics Semiconductor Display Technology Co., Ltd., Wuhan, Hubei 430079 (CN)
(72) Inventor: ZHANG, Huanxi, Wuhan, Hubei 430079 (CN)
(74) Representative: Studio Torta S.p.A.
(86) International application number: PCT/CN2023/134012
(87) International publication number: WO 2025/020388

(57) **Abstract**

The present application discloses a gate driving circuit and a display panel. The gate driving circuit includes a plurality of cascaded shift registers. An N^{th}-stage shift register includes a stage-transfer signal selection module, a pull-up control module, a first filtering module, a second filtering module, and a first output module. The gate driving circuit can retain a former part with a fixed width in a first pulse, and then control the first output module to output a gate driving signal with a pulse of the fixed width at a corresponding time.

## Description

### TECHNICAL FIELD

The present application relates to the field of display technology, and specifically relates to a gate driving circuit and a display panel.

### BACKGROUND

In a display panel, a gate driving circuit usually provides required gate driving signals for transistors corresponding to pixel circuits.

However, pulses of the gate driving signals provided by the gate driving circuit cannot always meet the driving timing sequence of the pixel circuits in terms of time and width. Therefore, this becomes one of the reasons for improving the gate driving circuit.

### SUMMARY

The present application provides a gate driving circuit and a display panel to alleviate the technical problem that pulses of gate driving signals are difficult to meet requirements in terms of time and width.

In a first aspect, the present application provides a gate driving circuit. The gate driving circuit includes a plurality of cascaded shift registers. An N^{th}-stage shift register includes a stage-transfer signal selection module, a pull-up control module, a first filtering module, a second filtering module, and a first output module. The stage-transfer signal selection module is electrically connected between a first node and a first wiring. The pull-up control module is configured to control a potential of a second node according to a potential of the first node and a potential of a first clock signal. The first filtering module is electrically connected between the second node and a third node, and a control terminal of the first filtering module is configured to access a reset signal. The second filtering module is electrically connected between the first filtering module and the third node, and a control terminal of the second filtering module is configured to access a filtering control signal having a plurality of pulses during one frame. The first output module is configured to output a first gate driving signal according to a potential of the third node and a potential of a fourth node.

In a second aspect, the present application provides a display panel. The display panel includes a pixel circuit and the gate driving circuit in at least one of the above embodiments. The pixel circuit includes a writing transistor configured to control input of a data signal, and a compensation transistor configured to control input of the data signal to a gate of a driving transistor. An output terminal of the first output module is electrically connected to a gate of the writing transistor, and an output terminal of the second output module is electrically connected to a gate of the compensation transistor.

### BRIEF DESCRIPTION OF THE DRAWINGS

FIG. 1 is a schematic structural diagram of a pixel circuit in existing technology.
FIG. 2 is a schematic timing sequence diagram of the pixel circuit shown in FIG. 1.
FIG. 3 is a schematic diagram of a first structure of a gate driving circuit provided by an embodiment of the present application.
FIG. 4 is a schematic timing sequence diagram of the gate driving circuit shown in FIG. 3.
FIG. 5 is a schematic state diagram of the gate driving circuit shown in FIG. 3 at a first stage in FIG. 4.
FIG. 6 is a schematic state diagram of the gate driving circuit shown in FIG. 3 at a second stage in FIG. 4.
FIG. 7 is a schematic state diagram of the gate driving circuit shown in FIG. 3 at a third stage in FIG. 4.
FIG. 8 is a schematic state diagram of the gate driving circuit shown in FIG. 3 at a fourth stage in FIG. 4.
FIG. 9 is a schematic state diagram of the gate driving circuit shown in FIG. 3 at a fifth stage in FIG. 4.
FIG. 10 is a schematic state diagram of the gate driving circuit shown in FIG. 3 at a sixth stage in FIG. 4.
FIG. 11 is a schematic state diagram of the gate driving circuit shown in FIG. 3 at a seventh stage in FIG. 4.
FIG. 12 is a schematic state diagram of the gate driving circuit shown in FIG. 3 at an eighth stage in FIG. 4.
FIG. 13 is a schematic state diagram of the gate driving circuit shown in FIG. 3 at a ninth stage in FIG. 4.
FIG. 14 is a schematic state diagram of the gate driving circuit shown in FIG. 3 at a tenth stage in FIG. 4.
FIG. 15 is a schematic state diagram of the gate driving circuit shown in FIG. 3 at an eleventh stage in FIG. 4.
FIG. 16 is a schematic state diagram of the gate driving circuit shown in FIG. 3 at a twelfth stage in FIG. 4.
FIG. 17 is a schematic state diagram of the gate driving circuit shown in FIG. 3 at a thirteenth stage in FIG. 4.
FIG. 18 is a schematic state diagram of the gate driving circuit shown in FIG. 3 at a fourteenth stage in FIG. 4.
FIG. 19 is a schematic state diagram of the gate driving circuit shown in FIG. 3 at a fifteenth stage in FIG. 4.
FIG. 20 is a schematic diagram of a second structure of the gate driving circuit provided by an embodiment of the present application.
FIG. 21 is a schematic timing sequence diagram of the gate driving circuit shown in FIG. 20.
FIG. 22 is a schematic state diagram of the gate driving circuit shown in FIG. 20 at a first stage in FIG. 21.
FIG. 23 is a schematic state diagram of the gate driving circuit shown in FIG. 20 at a second stage in FIG. 21.
FIG. 24 is a schematic state diagram of the gate driving circuit shown in FIG. 20 at a third stage in FIG. 21.
FIG. 25 is a schematic state diagram of the gate driving circuit shown in FIG. 20 at a fourth stage in FIG. 21.
FIG. 26 is a schematic state diagram of the gate driving circuit shown in FIG. 20 at a fifth stage in FIG. 21.
FIG. 27 is a schematic state diagram of the gate driving circuit shown in FIG. 20 at a sixth stage in FIG. 21.
FIG. 28 is a schematic state diagram of the gate driving circuit shown in FIG. 20 at a seventh stage in FIG. 21.
FIG. 29 is a schematic state diagram of the gate driving circuit shown in FIG. 20 at an eighth stage in FIG. 21.
FIG. 30 is a schematic timing sequence diagram of generation of an N^{th}-stage negative-pulse gate driving signal provided by an embodiment of the present application.
FIG. 31 is a schematic diagram of a cascaded structure between shift registers in the gate driving circuit shown in FIG. 3 or FIG. 20.
FIG. 32 is a schematic structural diagram of a display panel provided by an embodiment of the present application.
FIG. 33 is a schematic structural diagram of a pixel circuit provided by an embodiment of the present application.
FIG. 34 is a schematic timing sequence diagram of the pixel circuit shown in FIG. 33.

### DETAILED DESCRIPTION

To make the objectives, technical solutions, and effects of the present application clearer and more definite, the present application is further described in detail below with reference to the accompanying drawings and embodiments. It should be understood that the specific embodiments described herein are only used to explain the present application and are not intended to limit the present application.

In the gate driving circuit in the invention application with application number 202310191137.9, an N^{th}-stage negative-pulse gate driving signal Pout[N] has one negative pulse during one frame. An N^{th}-stage positive-pulse gate driving signal Nout[N] has two positive pulses during one frame, and the pulse widths of the two positive pulses must be equal and both be 2H. This limits that the widths of the positive pulses of the N^{th}-stage positive-pulse gate driving signal Nout[N] must be consistent and cannot be changed, so that when the width of the positive pulse of the N^{th}-stage positive-pulse gate driving signal Nout[N] is greater than 2H, the number of negative pulses of the N^{th}-stage negative-pulse gate driving signal Pout[N] during one frame will increase.

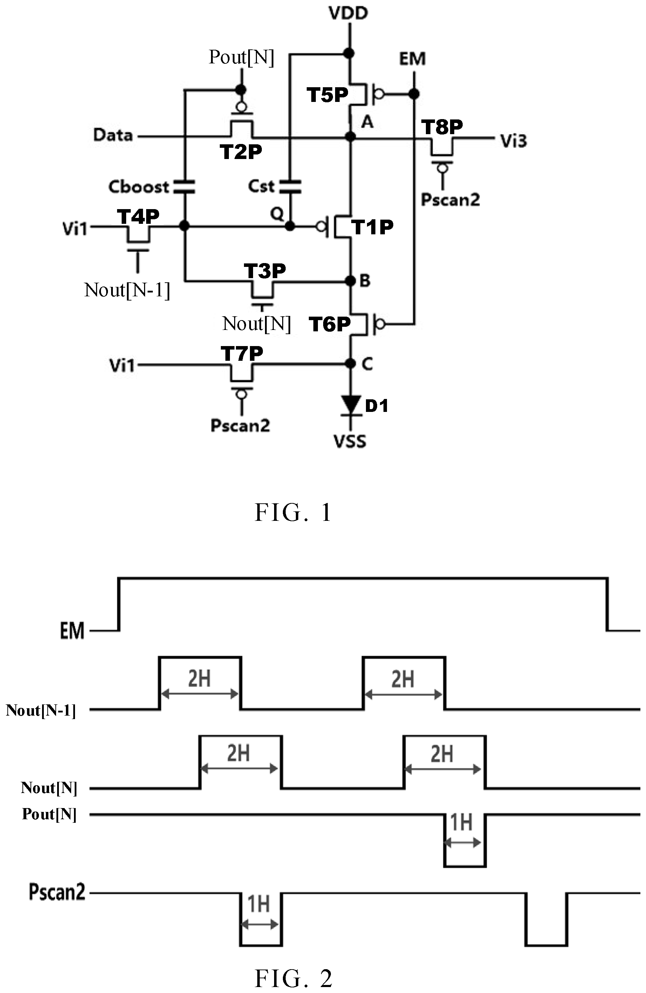

Therefore, this will restrict the pixel circuit shown in FIG. 1 from operating according to the timing sequence shown in FIG. 2. Specifically, the pixel circuit shown in FIG. 1 may include at least one of a writing transistor T2P, a driving transistor T1P, a first light-emitting control transistor T5P, a second light-emitting control transistor T6P, a first initialization transistor T4P, a second initialization transistor T7P, a third initialization transistor T8P, a compensation transistor T3P, a light-emitting component D1, a storage capacitor Cst, and a bootstrap capacitor CbOst.

A first power line is electrically connected to a first electrode of the first light-emitting control transistor T5P and one end of the storage capacitor Cst. A second electrode of the first light-emitting control transistor T5P is electrically connected to a first electrode of the driving transistor T1P and a first electrode of the writing transistor T2P. A second electrode of the driving transistor T1P is electrically connected to a first electrode of the compensation transistor T3P and a first electrode of the second light-emitting control transistor T6P. A second electrode of the second light-emitting control transistor T6P is electrically connected to a first electrode of the second initialization transistor T7P and an anode of the light-emitting component D1. A cathode of the light-emitting component D1 is electrically connected to a second power line.

A light-emitting control line is electrically connected to a gate of the first light-emitting control transistor T5P and a gate of the second light-emitting control transistor T6P.

A second electrode of the writing transistor T2P is electrically connected to a data line. A gate of the writing transistor T2P is electrically connected to a first scanning line and one end of the bootstrap capacitor CbOst. A second electrode of the second initialization transistor T7P is electrically connected to a second initialization line. A gate of the second initialization transistor T7P is electrically connected to a second scanning line.

A second electrode of the compensation transistor T3P is electrically connected to a gate of the driving transistor T1P. A gate of the compensation transistor T3P is electrically connected to a third scanning line.

A gate of the driving transistor T1P is electrically connected to another end of the storage capacitor Cst, another end of the bootstrap capacitor CbOst, and a first electrode of the first initialization transistor T4P.

A second electrode of the first initialization transistor T4P is electrically connected to a first initialization line. A gate of the first initialization transistor T4P is electrically connected to a fourth scanning line.

A first electrode of the third initialization transistor T8P is electrically connected to the first electrode of the driving transistor T1P. A second electrode of the third initialization transistor T8P is electrically connected to a third initialization line. A gate of the third initialization transistor T8P shares the second scanning line with the gate of the second initialization transistor T7P.

It should be noted that the second initialization line can also be replaced with the first initialization line, which can reduce one wiring required by the pixel circuit and is beneficial to increasing the density of the pixel circuit in the display panel.

In the present application, the first electrode may be one of a source and a drain, and the second electrode may be another of the source and the drain. For example, when the first electrode is the source, the second electrode is the drain; or, when the first electrode is the drain, the second electrode is the source.

The first power line is configured to transmit a positive power signal VDD, and the second power line is configured to transmit a negative power signal VSS. The potential of the positive power signal VDD is higher than that of the negative power signal VSS. The data line is configured to transmit a data signal Data. The light-emitting control line is configured to transmit a light-emitting control signal EM. The first initialization line is configured to transmit a first initialization signal Vi1. The second initialization line is configured to transmit a second initialization signal. The third initialization line is configured to transmit a third initialization signal Vi3. The first scanning line is configured to transmit the gate driving signal Pout[N]. The second scanning line is configured to transmit a gate driving signal Pscan2. The third scanning line is configured to transmit the gate driving signal Nout[N]. The fourth scanning line is configured to transmit a gate driving signal Nout[N-1].

The gate driving signal Pout[N], the gate driving signal Nout[N-1], and the gate driving signal Nout[N] may be provided by the gate driving circuit in the invention application with application number 202310191137.9. The gate driving signal Pout[N] is derived from the N^{th-}stage negative-pulse gate driving signal Pout[N], the gate driving signal Nout[N] is derived from the N^{th}-stage positive-pulse gate driving signal Nout[N], and the gate driving signal Nout[N-1] is derived from an (N-1)^{th}-stage positive-pulse gate driving signal Nout[N-1].

As can be seen from the above, in the invention application with application number 202310191137.9, the principle of generating one negative pulse of the N^{th}-stage negative-pulse gate driving signal Pout[N] during one frame is formed by filtering out a first pulse of a start control signal STV or an (N-Y)^{th}-stage positive-pulse gate driving signal Nout[N-Y] through a second pulse of a reset signal RST. Therefore, the widths of the two positive pulses of the start control signal STV or the (N-Y)^{th}-stage positive-pulse gate driving signal Nout[N-Y] must be equal.

In the pixel circuit shown in FIG. 1, to realize synchronous conduction of the compensation transistor T3P and the first initialization transistor T4P, the pulse of the gate driving signal Nout[N-1] and the pulse of the gate driving signal Nout[N] need to partially overlap, which is also the reason why the first initialization transistor T4P in the pixel circuit shown in FIG. 1 must access the gate driving signal Nout[N-1].

In addition, to transmit the third initialization signal Vi3 to a node Q sequentially through a node A and a node B to reset the potentials of the node A, the node B, and the node Q, the third initialization transistor T8P and the compensation transistor T3P need to be turned on synchronously, which requires partial overlap between the pulse of the gate driving signal Pscan2 and the pulse of the gate driving signal Nout[N].

In order for the pixel circuit shown in FIG. 1 to continue using the gate driving signal Pscan2 with a pulse width of only 1H, it is necessary to adjust the driving timing sequence of the pixel circuit shown in FIG. 2, and correspondingly, it is also necessary to improve the gate driving circuit in the invention application with application number 202310191137.9.

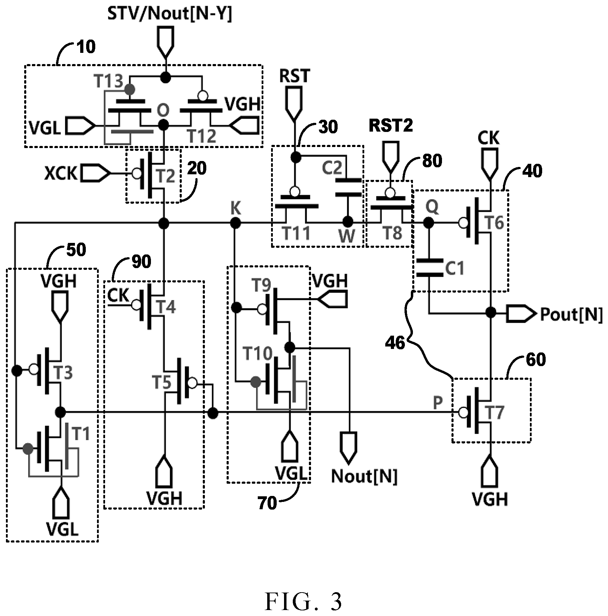

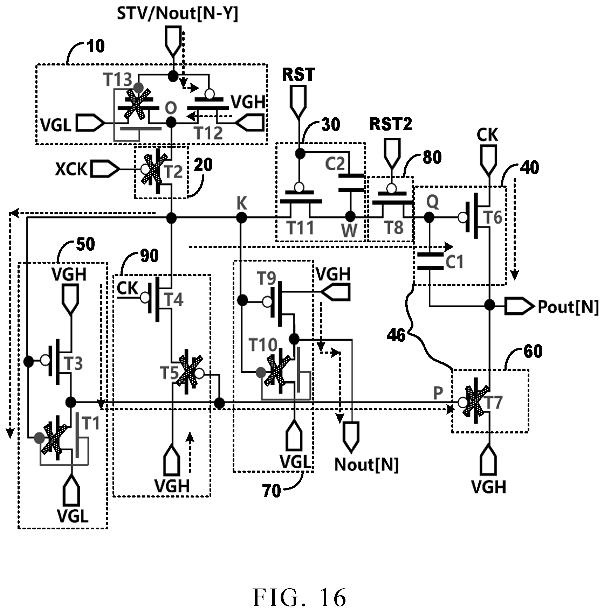

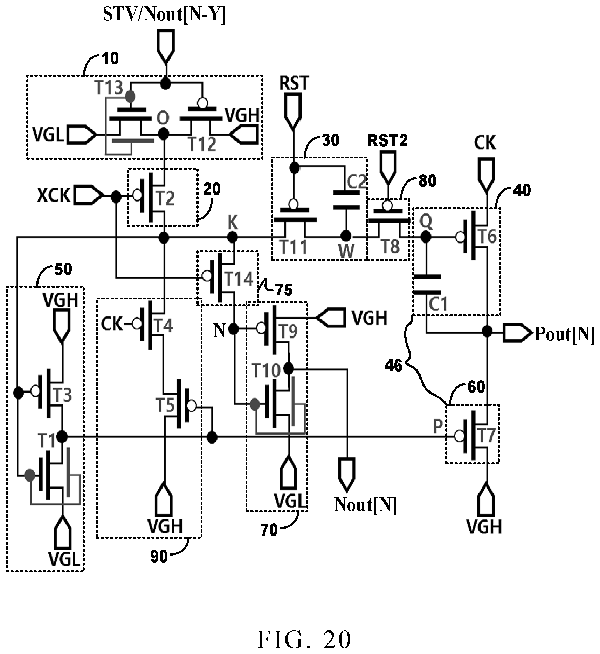

Against this background, to alleviate the technical problem that pulses of gate driving signals are difficult to meet requirements in terms of time and width, the present embodiment provides a gate driving circuit. Please refer to FIG. 3 to FIG. 30. As shown in FIG. 3 and FIG. 20, the gate driving circuit includes a plurality of cascaded shift registers. An N^{th}-stage shift register includes at least one of a stage-transfer signal selection module 10, a pull-up control module 20, a first filtering module 30, a second filtering module 80, and a first output module 46.

The stage-transfer signal selection module 10 is electrically connected between a first node O and a first wiring, where Y is an integer greater than or equal to 1.

The pull-up control module 20 controls the potential of a second node K according to the potential of the first node O and the potential of a first clock signal.

The first filtering module 30 is electrically connected between the second node K and a third node Q, and a control terminal of the first filtering module 30 accesses the reset signal RST.

The second filtering module 80 is electrically connected between the first filtering module 30 and the third node Q, and a control terminal of the second filtering module 80 accesses a filtering control signal RST2 having a plurality of pulses during one frame.

The first output module 46 outputs a first gate driving signal according to the potential of the third node Q and the potential of a fourth node P.

It can be understood that, in the gate driving circuit provided by the present embodiment, the first filtering module 30 filters out a former part in a second pulse that appears later of the second node K during one frame, and the second filtering module 80 filters out a latter part in a first pulse that appears earlier and a latter part in the second pulse that appears later of the second node K during one frame, so that a former part with a fixed width in the first pulse can be retained. Then, the first output module 46 is controlled to output a gate driving signal with a pulse of the fixed width at a corresponding time. After such improvement, the gate driving circuit can meet the driving requirements of the back-end.

In one embodiment, the N^{th}-stage shift register further includes a first inverting module 50 and a second output module 70. The first inverting module 50 is electrically connected between the second node K and the fourth node P. The second output module 70 outputs a second gate driving signal according to the potential of the second node K.

It can be understood that after the improvement shown in FIG. 3 and FIG. 20 to that shown in FIG. 1, since the first filtering module 30 can filter out the former part in the second pulse that appears later of the second node K during one frame, and the second filtering module 80 can filter out the latter part in the first pulse that appears earlier and the latter part in the second pulse that appears later of the second node K during one frame, the former part with a fixed width in the first pulse can be retained. Then, the first output module 46 is controlled to output the gate driving signal with a pulse of the fixed width at a corresponding time. The pulse width of the N^{th-}stage positive-pulse gate driving signal Nout[N] provided by the second output module 70 will not affect the pulse width of the N^{th}-stage negative-pulse gate driving signal Pout[N]. Therefore, the widths of the two pulses of the N^{th}-stage positive-pulse gate driving signal Nout[N] during one frame can not only be modulated to be greater than 2H, but also the two pulse widths can be modulated respectively without keeping them equal. This provides support for the improvement of the driving timing sequence of the pixel circuit.

In one embodiment, the frequency of the second gate driving signal is the same as the frequency of the filtering control signal RST2, and the phase of the second gate driving signal is different from the phase of the filtering control signal RST2.

It should be noted that the present embodiment can use a shifted N^{th}-stage positive-pulse gate driving signal Nout[N], such as an (N-2)^{th}-stage positive-pulse gate driving signal Nout[N-2], as the filtering control signal RST2, which can not only obtain the desired first gate driving signal and second gate driving signal, but also avoid introducing an external control signal as the filtering control signal RST2. In other embodiments, an external control signal can also be used as the filtering control signal RST2. In other embodiments, the potential of the fourth node P in the (N-2)^{th}-stage shift register can also be used as the filtering control signal RST2.

In other embodiments, positive-pulse gate driving signals of other stages can also be selected according to the requirements of the first gate driving signal and the second gate driving signal.

In one embodiment, the frequency of the second gate driving signal is the same as the frequency of the reset signal RST, and the phase of the second gate driving signal is different from the phase of the reset signal RST.

It should be noted that the present embodiment can use a shifted N^{th}-stage positive-pulse gate driving signal Nout[N], such as an (N-X)^{th}-stage positive-pulse gate driving signal Nout[N-X], as the reset signal RST, which can not only obtain the desired first gate driving signal and second gate driving signal, but also avoid introducing an external control signal as the reset signal RST. In other embodiments, an external control signal can also be used as the reset signal RST. In other embodiments, the potential of the fourth node P in the (N-X)^{th}-stage shift register can also be used as the reset signal RST. Where X is an integer greater than or equal to 2.

In one embodiment, as shown in FIG. 3 and FIG. 20, the first filtering module 30 includes a first filtering transistor T11 and a first capacitor C2. One of a source and a drain of the first filtering transistor T11 is electrically connected to the second node K, and another of the source and the drain of the first filtering transistor T11 is electrically connected to the third node Q. A gate of the first filtering transistor T11 accesses the reset signal RST. One end of the first capacitor C2 is electrically connected to the gate of the first filtering transistor T11, and another end of the first capacitor C2 is electrically connected to another of the source and the drain of the first filtering transistor T11.

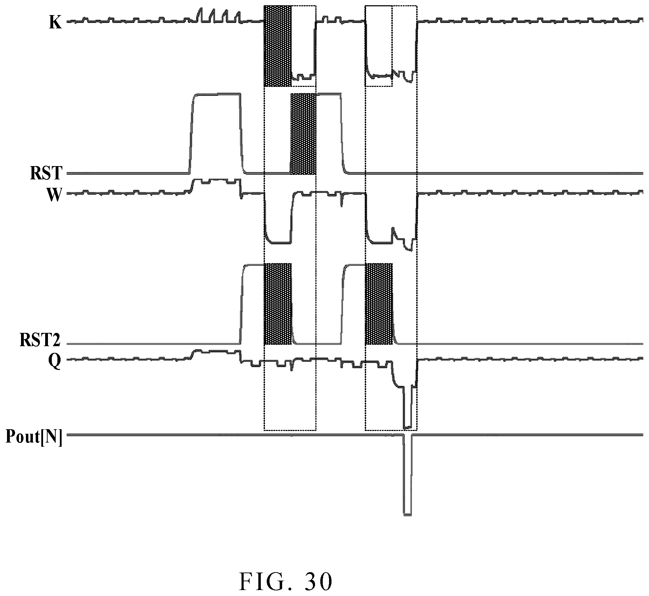

It should be noted that, as shown in FIG. 30, the first filtering module 30 is configured to filter out a former part in a second pulse that appears later of the second node K during one frame.

In one embodiment, as shown in FIG. 3 and FIG. 20, the second filtering module 80 includes a second filtering transistor T8. One of a source and a drain of the second filtering transistor T8 is electrically connected to the first filtering module 30, and another of the source and the drain of the second filtering transistor T8 is electrically connected to the third node Q. A gate of the second filtering transistor T8 accesses the filtering control signal RST2.

It should be noted that, as shown in FIG. 30, the second filtering module 80 is configured to filter out a latter part in a first pulse that appears earlier and a latter part in the second pulse that appears later of the second node K during one frame.

It can be seen from the above that the first filtering module 30 and the second filtering module 80 are configured to filter out the second pulse and retain a former part with a fixed width in the first pulse.

In one embodiment, as shown in FIG. 20, the N^{th}-stage shift register further includes an isolation module 75. The isolation module 75 is connected in series between the second node K and an input terminal of the second output module 70, and a control terminal of the isolation module 75 accesses the first clock signal.

It should be noted that the isolation module 75 is configured to reduce coupling of a pulse amplitude of the N^{th}-stage negative-pulse gate driving signal Pout[N] to a pulse amplitude of the N^{th}-stage positive-pulse gate driving signal Nout[N], thereby stabilizing a high potential of the N^{th}-stage positive-pulse gate driving signal Nout[N].

In one embodiment, as shown in FIG. 20, the isolation module 75 includes an isolation transistor T14. One of a source and a drain of the isolation transistor T14 is electrically connected to the second node K, and another of the source and the drain of the isolation transistor T14 is electrically connected to the input terminal of the second output module 70. A gate of the isolation transistor T14 accesses the first clock signal, and the isolation transistor T14 is a P-channel thin film transistor.

It should be noted that the isolation transistor T14 can reduce coupling of the pulse amplitude of the N^{th}-stage negative-pulse gate driving signal Pout[N] to the pulse amplitude of the N^{th}-stage positive-pulse gate driving signal Nout[N], thereby stabilizing the high potential of the N^{th}-stage positive-pulse gate driving signal Nout[N].

In other embodiments, the isolation module 75 may further include a component connected in series between a gate of the isolation transistor T14 and a node N.

An input terminal of the stage-transfer signal selection module 10 is electrically connected to a start control line or an (N-Y)^{th}-stage positive-pulse scanning line, where N is an integer greater than or equal to 1, and Y is an integer greater than or equal to 1.

An input terminal of the pull-up control module 20 is electrically connected to an output terminal of the stage-transfer signal selection module 10, and a control terminal of the pull-up control module 20 is electrically connected to a first clock line.

An input terminal of the first filtering module 30 is electrically connected to an output terminal of the pull-up control module 20, and a control terminal of the first filtering module 30 is electrically connected to a reset line.

An input terminal of the second output module 70 is electrically connected to the input terminal of the pull-up control module 20, and an output terminal of the second output module 70 is electrically connected to an N^{th}-stage positive-pulse scanning line. The number of positive pulses output by the N^{th}-stage positive-pulse scanning line during one frame is greater than the number of negative pulses output by an N^{th}-stage negative-pulse scanning line during one frame.

In one embodiment, the first output module 46 includes a pull-up module 40 and a pull-down module 60. A control terminal of the pull-up module 40 is electrically connected to an output terminal of the first filtering module 30, an input terminal of the pull-up module 40 is electrically connected to a second clock line, and an output terminal of the pull-up module 40 is electrically connected to the N^{th}-stage negative-pulse scanning line. An input terminal of the first inverting module 50 is electrically connected to the output terminal of the pull-up control module 20.

A control terminal of the pull-down module 60 is electrically connected to an output terminal of the first inverting module 50, an input terminal of the pull-down module 60 is electrically connected to a high-potential line, and an output terminal of the pull-down module 60 is electrically connected to the N^{th}-stage negative-pulse scanning line.

It should be noted that the first wiring may be the start control line or the (N-Y)^{th-}stage positive-pulse scanning line; when N-Y is less than or equal to 0, the first wiring is the start control line. The N^{th}-stage positive-pulse scanning line, i.e., a second gate control line, is configured to transmit the N^{th}-stage positive-pulse gate driving signal Nout[N], i.e., the second gate driving signal. The N^{th}-stage negative-pulse scanning line, i.e., a first gate control line, is configured to transmit the N^{th}-stage negative-pulse gate driving signal Pout[N], i.e., the first gate driving signal.

In one embodiment, a ratio of a channel width to a channel length of the first filtering transistor T11 is greater than or equal to 0.5 and less than or equal to 1.5.

It should be noted that the present embodiment is beneficial to ensuring the output stability of the N^{th}-stage negative-pulse gate driving signal Pout[N] and avoiding a coupling pull-down phenomenon before the arrival of the negative pulse.

In one embodiment, the pull-up module 40 includes a pull-up transistor T6 and a second capacitor C1. A gate of the pull-up transistor T6 is electrically connected to one of the source and the drain of the first filtering transistor T11. One of a source and a drain of the pull-up transistor T6 is electrically connected to the second clock line, and another of the source and the drain of the pull-up transistor T6 is electrically connected to the N^{th}-stage negative-pulse scanning line. One end of the second capacitor C1 is electrically connected to the gate of the pull-up transistor T6, and another end of the second capacitor C1 is electrically connected to another of the source and the drain of the pull-up transistor T6. A ratio of a capacitance of the first capacitor C2 to a capacitance of the second capacitor C1 is greater than or equal to 0.5.

It should be noted that the present embodiment designs the ratio of the capacitance of the first capacitor C2 to the capacitance of the second capacitor C1, which is beneficial to further ensuring the output stability of the N^{th}-stage negative-pulse gate driving signal Pout[N] and avoiding the coupling pull-down phenomenon before the arrival of the negative pulse.

Specifically, the capacitance of the first capacitor C2 may be greater than or equal to 50 fF. The capacitance of the second capacitor C1 may be greater than or equal to 100 fF.

A ratio of a channel width to a channel length of the pull-up transistor T6 is greater than 30:1, which is beneficial to further ensuring the output stability of the N^{th}-stage negative-pulse gate driving signal Pout[N]. The pull-up transistor T6 may be a P-channel thin film transistor.

In one embodiment, the stage-transfer signal selection module 10 includes a transistor T13 and a transistor T12. One of a source and a drain of the transistor T13 is electrically connected to a low-potential line, and another of the source and the drain of the transistor T13 is electrically connected to the input terminal of the pull-up control module 20. A first gate of the transistor T13 is electrically connected to the start control line or the (N-Y)^{th}-stage positive-pulse scanning line, and the first gate of the transistor T13 is electrically connected to a second gate of the transistor T13. The transistor T13 is an N-channel thin film transistor. One of a source and a drain of the transistor T12 is electrically connected to the high-potential line, and another of the source and the drain of the transistor T12 is electrically connected to another of the source and the drain of the transistor T13. A gate of the transistor T12 is electrically connected to the first gate of the transistor T13. The transistor T12 is a P-channel thin film transistor.

It should be noted that the stage-transfer signal selection module 10 in the present embodiment not only objectively has an inverting function, that is, the potential of an input signal is opposite to the potential of an output signal at the same time, but also plays a role in enabling the N^{th}-stage positive-pulse gate driving signal Nout[N] to serve as a stage transfer signal between shift registers. Otherwise, stage transfer cannot be realized between shift registers, which will cause the gate driving circuit to fail to normally provide corresponding gate driving signals.

A ratio of a channel width to a channel length of the transistor T13 is greater than 2:1. A ratio of a channel width to a channel length of the transistor T12 ranges from 0.5:1 to 3:1.

The high-potential line is configured to transmit a high-potential signal VGH, and the high-potential signal VGH can control the N-channel thin film transistor to be turned on or control the P-channel thin film transistor to be turned off. The low-potential line is configured to transmit a low-potential signal VGL, and the low-potential signal VGL can control the P-channel thin film transistor to be turned on or control the N-channel thin film transistor to be turned off.

In one embodiment, the pull-up control module 20 includes a pull-up control transistor T2. One of a source and a drain of the pull-up control transistor T2 is electrically connected to the output terminal of the stage-transfer signal selection module 10, and another of the source and the drain of the pull-up control transistor T2 is electrically connected to the input terminal of the first filtering module 30. A gate of the pull-up control transistor T2 is electrically connected to the first clock line.

It should be noted that the pull-up control transistor T2 may be a P-channel thin film transistor. A ratio of a channel width to a channel length of the pull-up control transistor T2 ranges from 0.5:1 to 3:1.

In one embodiment, the first inverting module 50 includes a transistor T3 and a transistor T1. One of a source and a drain of the transistor T3 is electrically connected to the high-potential line, and another of the source and the drain of the transistor T3 is electrically connected to one of a source and a drain of the transistor T1 and the control terminal of the pull-down module 60. Another of the source and the drain of the transistor T1 is electrically connected to the low-potential line. An output terminal of the pull-up control module 20 is electrically connected to a gate of the transistor T3, a first gate of the transistor T1, and a second gate of the transistor T1.

It should be noted that the transistor T3 is a P-channel thin film transistor. The transistor T1 is a double-gate N-channel thin film transistor. This can improve the dynamic performance of the transistor T3 and the transistor T1, thereby improving the dynamic performance of the first inverting module 50.

A ratio of a channel width to a channel length of the transistor T3 ranges from 0.5:1 to 3:1. A ratio of a channel width to a channel length of the transistor T1 is greater than or equal to 2:1.

In one embodiment, the pull-down module 60 includes a pull-down transistor T7. One of a source and a drain of the pull-down transistor T7 is electrically connected to the high-potential line, and another of the source and the drain of the pull-down transistor T7 is electrically connected to the N^{th}-stage negative-pulse scanning line. A gate of the pull-down transistor T7 is electrically connected to an output terminal of the first inverting module 50, i.e., the fourth node P.

It should be noted that the pull-down transistor T7 may be a P-channel thin film transistor. Under the combined action of the pull-down module 60 and the pull-up module 40, the required N^{th}-stage negative-pulse gate driving signal Pout[N] can be modulated.

A ratio of a channel width to a channel length of the pull-down transistor T7 is greater than or equal to 30:1.

In one embodiment, the second output module 70 includes a transistor T9 and a transistor T10. One of a source and a drain of the transistor T9 is electrically connected to the high-potential line, and another of the source and the drain of the transistor T9 is electrically connected to one of a source and a drain of the transistor T10 and the N^{th}-stage positive-pulse scanning line. Another of the source and the drain of the transistor T10 is electrically connected to the low-potential line. An output terminal of the pull-up control module 20 is electrically connected to a gate of the transistor T9, a first gate of the transistor T10, and a second gate of the transistor T10.

It should be noted that the transistor T9 is a P-channel thin film transistor. The transistor T10 is a double-gate N-channel thin film transistor. This can improve the dynamic performance of the transistor T9 and the transistor T10, thereby improving the dynamic performance of the second output module 70.

A ratio of a channel width to a channel length of the transistor T9 is greater than or equal to 30:1. A ratio of a channel width to a channel length of the transistor T10 is greater than or equal to 30:1.

In one embodiment, the N^{th}-stage shift register further includes a feedback module 90. The feedback module 90 includes a transistor T4 and a transistor T5. One of a source and a drain of the transistor T4 is electrically connected to the output terminal of the pull-up control module 20, a gate of the transistor T4 is electrically connected to the second clock line, and another of the source and the drain of the transistor T4 is electrically connected to one of a source and a drain of the transistor T5. Another of the source and the drain of the transistor T5 is electrically connected to the high-potential line, and a gate of the transistor T5 is electrically connected to the output terminal of the first inverting module 50.

Where a ratio of a channel width to a channel length of the transistor T4 ranges from 0.5:1 to 3:1. A ratio of a channel width to a channel length of the transistor T5 ranges from 0.5:1 to 3:1.

It should be noted that the feedback module 90 can maintain the second node K at a high potential according to the potential of the fourth node P and the potential of the second clock line. That is, when the fourth node P is at a low potential and the second clock signal CK is at a low potential, the high-potential line can control the potential of the second node K to the potential of the high-potential signal VGH.

It should be noted that the N^{th}-stage positive-pulse scanning line is configured to transmit the N^{th}-stage positive-pulse gate driving signal Nout[N]. The N^{th}-stage negative-pulse scanning line is configured to transmit the N^{th}-stage negative-pulse gate driving signal Pout[N]. The first clock line is configured to transmit the first clock signal XCK. The second clock line is configured to transmit the second clock signal CK. The start control line is configured to transmit the start control signal STV. The (N-Y)^{th}-stage positive-pulse scanning line is configured to transmit the (N-Y)^{th}-stage positive-pulse gate driving signal Nout[N-Y]. The (N-X)^{th}-stage positive-pulse scanning line is configured to transmit the (N-X)^{th}-stage positive-pulse gate driving signal Nout[N-X]. The reset line is configured to transmit the reset signal RST.

For other parts of the gate driving circuit shown in FIG. 3 and FIG. 20, reference can be made to the detailed introduction of the gate driving circuit shown in FIG. 1, which will not be repeated here.

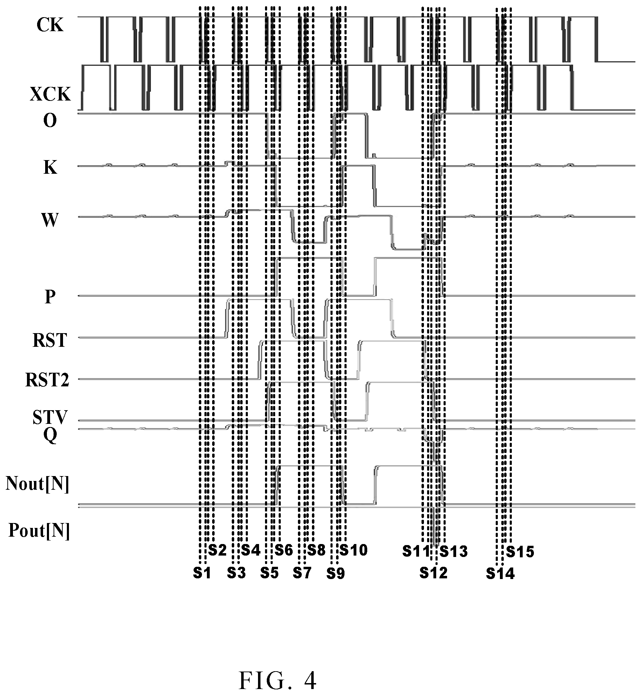

The operating process of the shift register shown in FIG. 3 during one frame may include the following stages as shown in FIG. 4:

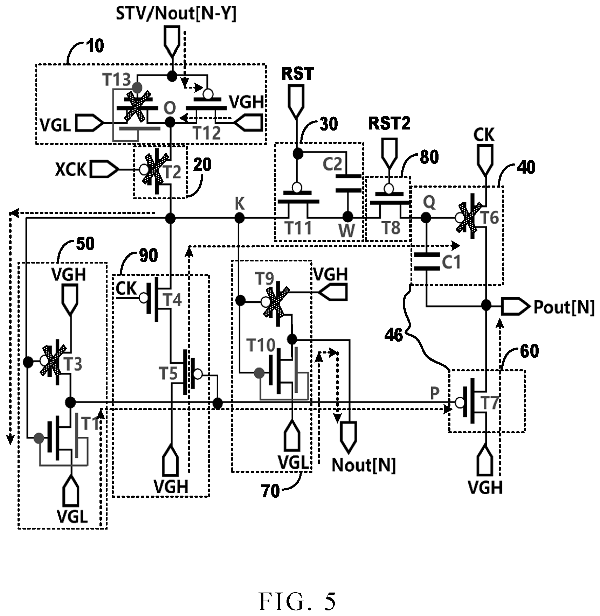

First stage S1: As shown in FIG. 4 and FIG. 5, the start control signal STV, the reset signal RST, the second clock signal CK, and the (N-2) ^{th}-stage positive-pulse gate driving signal Nout[N-2] are all at a low potential; the first clock signal XCK is at a high potential; the first node O, the second node K, the node W, and the third node Q are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

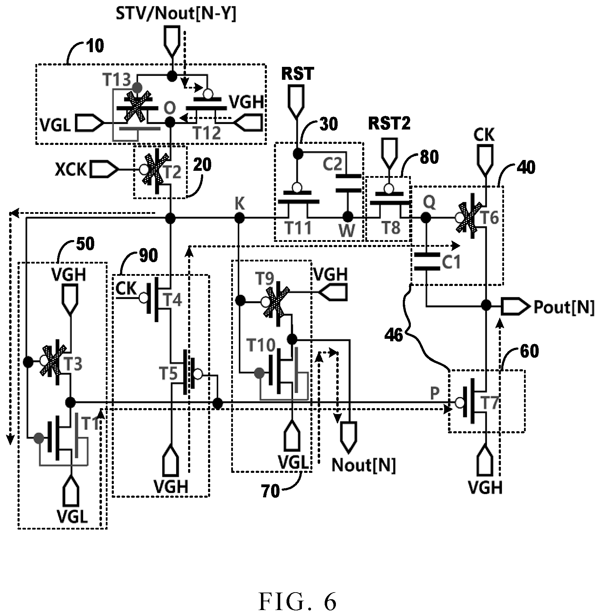

Second stage S2: As shown in FIG. 4 and FIG. 6, the start control signal STV, the reset signal RST, the first clock signal XCK, and the (N-2)^{th}-stage positive-pulse gate driving signal Nout[N-2] are all at a low potential; the second clock signal CK is at a high potential; the first node O, the second node K, the node W, and the third node Q are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

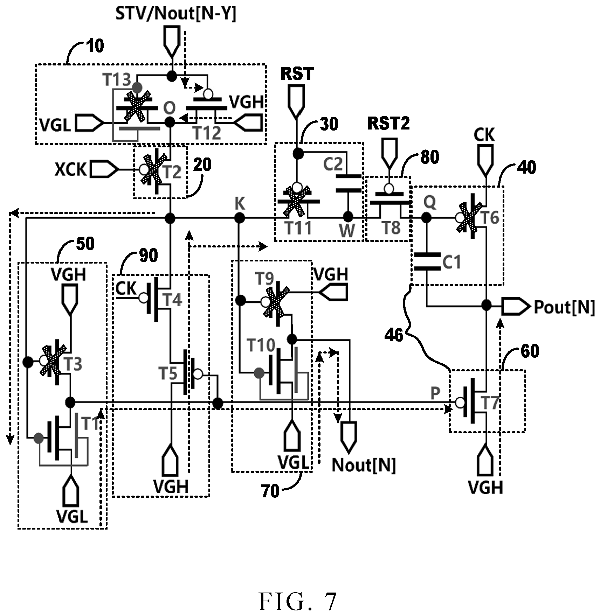

Third stage S3: As shown in FIG. 4 and FIG. 7, the start control signal STV, the second clock signal CK, and the (N-2)^{th}-stage positive-pulse gate driving signal Nout[N-2] are all at a low potential; the reset signal RST and the first clock signal XCK are at a high potential; the first node O, the second node K, the node W, and the third node Q are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

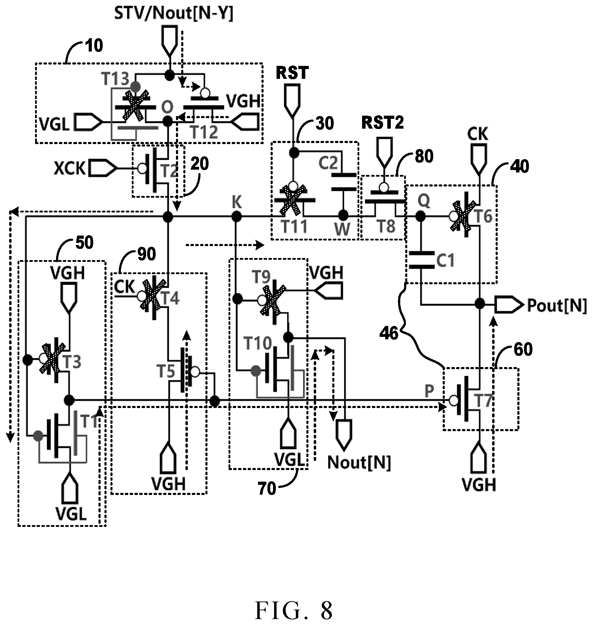

Fourth stage S4: As shown in FIG. 4 and FIG. 8, the start control signal STV, the first clock signal XCK, and the (N-2)^{th}-stage positive-pulse gate driving signal Nout[N-2] are all at a low potential; the reset signal RST and the second clock signal CK are at a high potential; the first node O, the second node K, the node W, and the third node Q are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

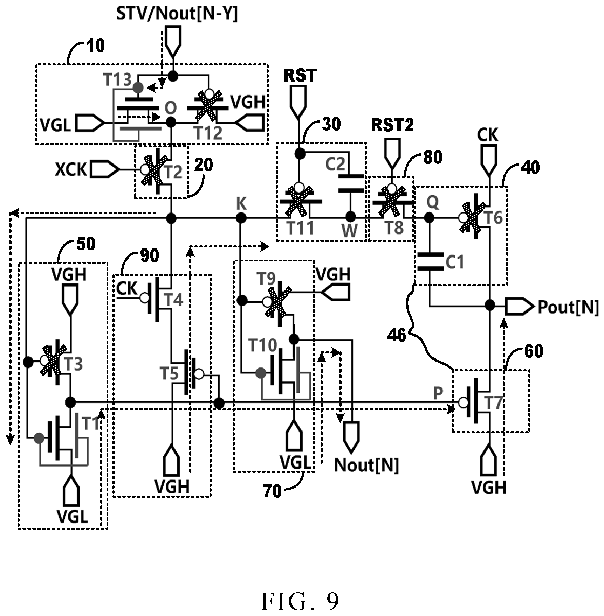

Fifth stage S5: As shown in FIG. 4 and FIG. 9, the second clock signal CK is at a low potential; the start control signal STV, the reset signal RST, the first clock signal XCK, and the (N-2)^{th}-stage positive-pulse gate driving signal Nout[N-2] are at a high potential; the second node K, the node W, and the third node Q are all at a high potential; the first node O and the fourth node P are at a low potential; the N^{th}-stage positive-pulse gate driving signal Nout[N] is at a low potential; and the N^{th}-stage negative-pulse gate driving signal Pout[N] is at a high potential.

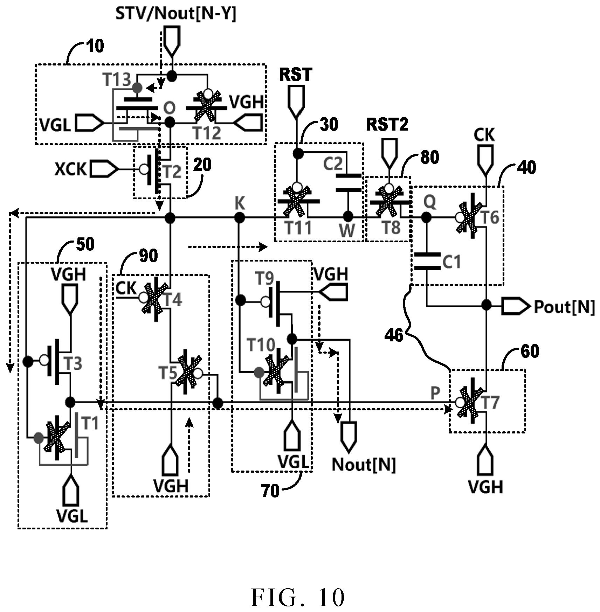

Sixth stage S6: As shown in FIG. 4 and FIG. 10, the first clock signal XCK is at a low potential; the start control signal STV, the reset signal RST, the second clock signal CK, and the (N-2)^{th}-stage positive-pulse gate driving signal Nout[N-2] are at a high potential; the node W, the fourth node P, and the third node Q are all at a high potential; the second node K and the first node O are at a low potential; the N^{th}-stage positive-pulse gate driving signal Nout[N] is at a high potential; and the N^{th}-stage negative-pulse gate driving signal Pout[N] is at a high potential.

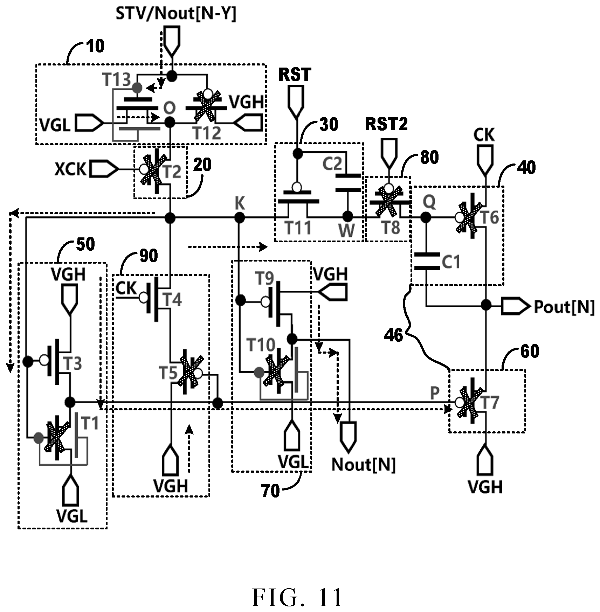

Seventh stage S7: As shown in FIG. 4 and FIG. 11, the reset signal RST and the second clock signal CK are at a low potential; the start control signal STV, the first clock signal XCK, and the (N-2)^{th}-stage positive-pulse gate driving signal Nout[N-2] are at a high potential; the fourth node P and the third node Q are all at a high potential; the node W, the second node K, and the first node O are at a low potential; the N^{th}-stage positive-pulse gate driving signal Nout[N] is at a high potential; and the N^{th}-stage negative-pulse gate driving signal Pout[N] is at a high potential.

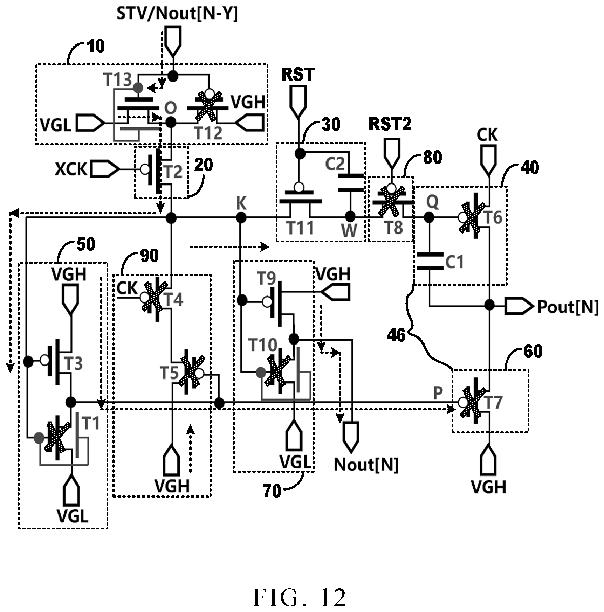

Eighth stage S8: As shown in FIG. 4 and FIG. 12, the reset signal RST and the first clock signal XCK are at a low potential; the start control signal STV, the second clock signal CK, and the (N-2)^{th}-stage positive-pulse gate driving signal Nout[N-2] are at a high potential; the fourth node P and the third node Q are all at a high potential; the node W, the second node K, and the first node O are at a low potential; the N^{th}-stage positive-pulse gate driving signal Nout[N] is at a high potential; and the N^{th}-stage negative-pulse gate driving signal Pout[N] is at a high potential.

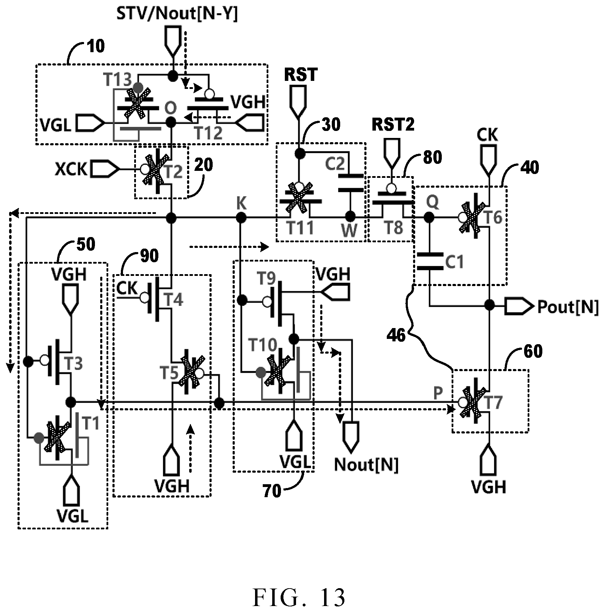

Ninth stage S9: As shown in FIG. 4 and FIG. 13, the second clock signal CK and the (N-2)^{th}-stage positive-pulse gate driving signal Nout[N-2] are at a low potential; the reset signal RST, the start control signal STV, and the first clock signal XCK are at a high potential; the node W, the first node O, the fourth node P, and the third node Q are all at a high potential; the second node K is at a low potential; the N^{th}-stage positive-pulse gate driving signal Nout[N] is at a high potential; and the N^{th}-stage negative-pulse gate driving signal Pout[N] is at a high potential.

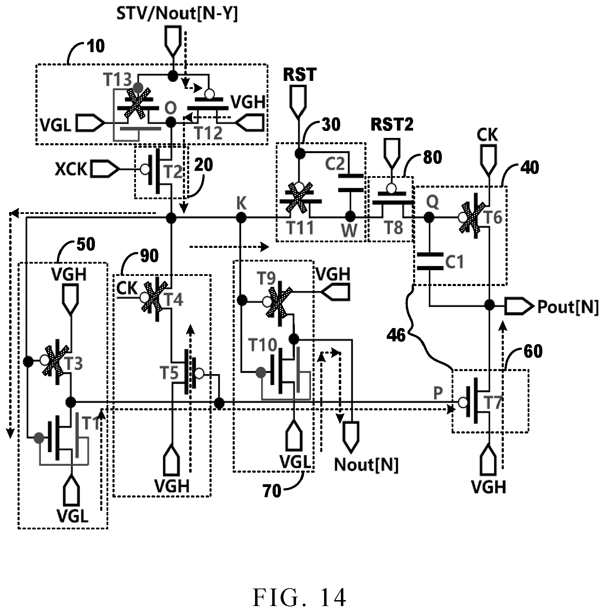

Tenth stage S10: As shown in FIG. 4 and FIG. 14, the start control signal STV, the first clock signal XCK, and the (N-2)^{th}-stage positive-pulse gate driving signal Nout[N-2] are at a low potential; the reset signal RST and the second clock signal CK are at a high potential; the second node K, the node W, the first node O, and the third node Q are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

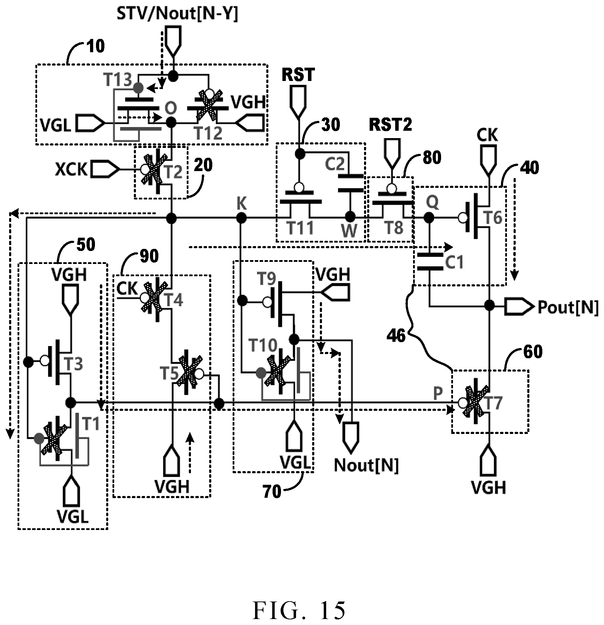

Eleventh stage S11: As shown in FIG. 4 and FIG. 15, the reset signal RST and the (N-2)^{th}-stage positive-pulse gate driving signal Nout[N-2] are at a low potential; the start control signal STV, the first clock signal XCK, and the second clock signal CK are at a high potential; the fourth node P and the third node Q are all at a high potential; the second node K, the node W, and the first node O are at a low potential; the N^{th}-stage positive-pulse gate driving signal Nout[N] is at a high potential; and the N^{th}-stage negative-pulse gate driving signal Pout[N] is at a high potential.

Twelfth stage S12: The second clock signal CK, the start control signal STV, the reset signal RST, and the (N-2)^{th}-stage positive-pulse gate driving signal Nout[N-2] are at a low potential; the first clock signal XCK is at a high potential; the fourth node P and the first node O are all at a high potential; the third node Q, the second node K, and the node W are at a low potential; the N^{th}-stage positive-pulse gate driving signal Nout[N] is at a high potential; and the N^{th}-stage negative-pulse gate driving signal Pout[N] is at a low potential.

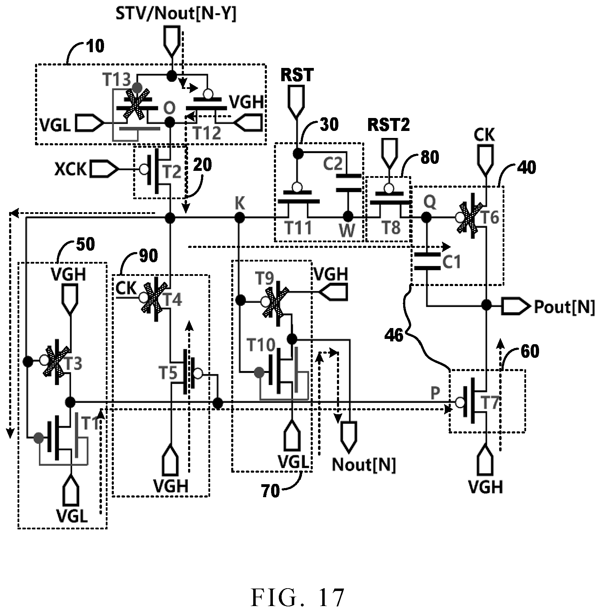

Thirteenth stage S13: As shown in FIG. 4 and FIG. 17, the first clock signal XCK, the start control signal STV, the reset signal RST, and the (N-2)^{th}-stage positive-pulse gate driving signal Nout[N-2] are at a low potential; the second clock signal CK is at a high potential; the second node K, the node W, the third node Q, and the first node O are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

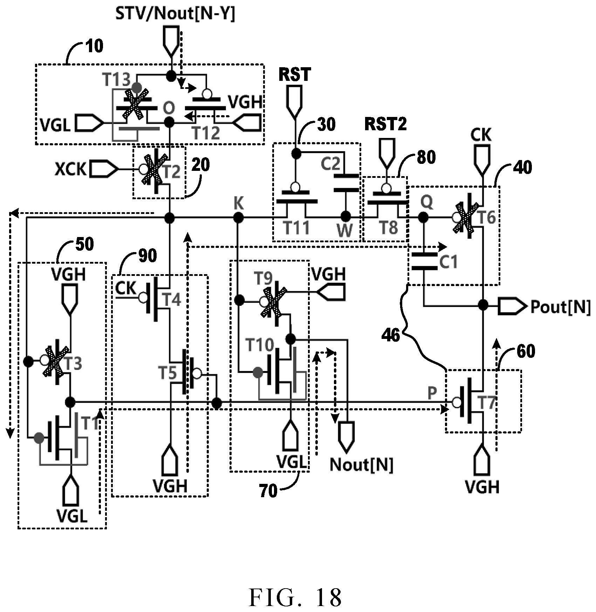

Fourteenth stage S14: As shown in FIG. 4 and FIG. 18, the second clock signal CK, the start control signal STV, the reset signal RST, and the (N-2)^{th}-stage positive-pulse gate driving signal Nout[N-2] are at a low potential; the first clock signal XCK is at a high potential; the second node K, the node W, the third node Q, and the first node O are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

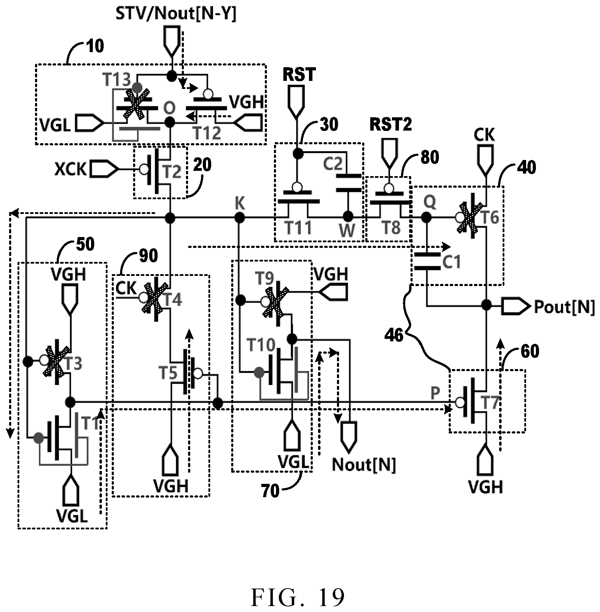

Fifteenth stage S15: As shown in FIG. 4 and FIG. 19, the first clock signal XCK, the start control signal STV, the reset signal RST, and the (N-2)^{th}-stage positive-pulse gate driving signal Nout[N-2] are at a low potential; the second clock signal CK is at a high potential; the second node K, the node W, the third node Q, and the first node O are all at a high potential; the fourth node P is at a low potential; the N^{th}-stage positive-pulse gate driving signal Nout[N] is at a low potential; and the N^{th}-stage negative-pulse gate driving signal Pout[N] is at a high potential.

It should be noted that the "cross" in FIG. 5 to FIG. 19 indicates that the transistor covered by the "cross" is in an off state, and the transistor not covered by the "cross" is in an on state. The dashed arrows in FIG. 5 to FIG. 19 indicate the current direction.

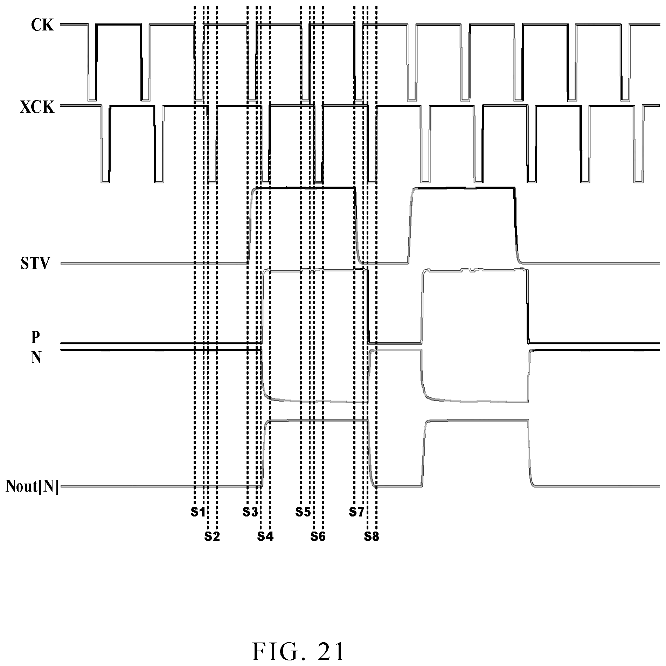

The operating process of the shift register shown in FIG. 20 during one frame may include the following stages as shown in FIG. 21:

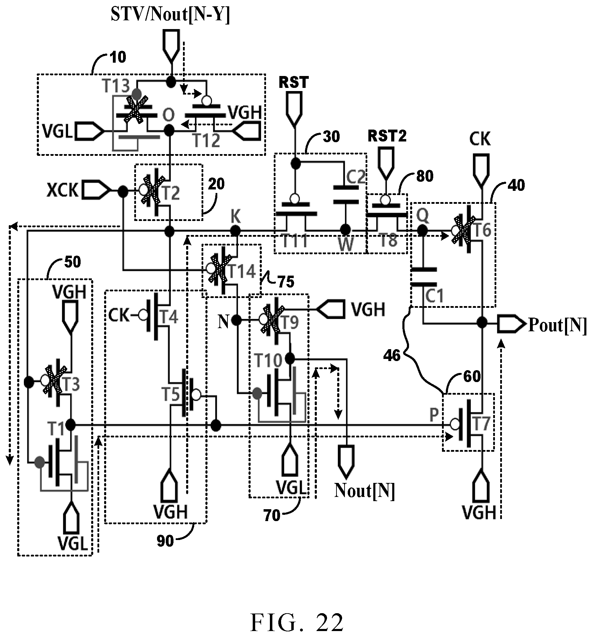

First stage S1: As shown in FIG. 21 and FIG. 22, the start control signal STV and the second clock signal CK are both at a low potential; the first clock signal XCK is at a high potential; the node N is at a high potential; the fourth node P is at a low potential; and the N^{th}-stage positive-pulse gate driving signal Nout[N] is at a low potential.

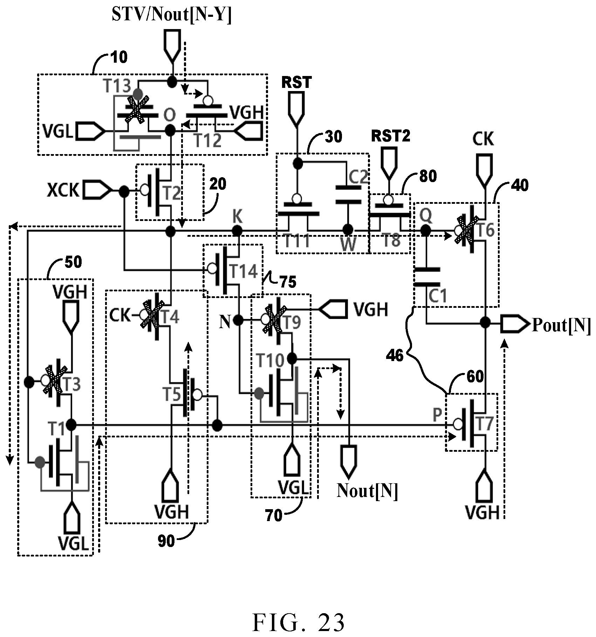

Second stage S2: As shown in FIG. 21 and FIG. 23, the start control signal STV and the first clock signal XCK are at a low potential; the second clock signal CK is at a high potential; the node N is at a high potential; the fourth node P is at a low potential; and the N^{th}-stage positive-pulse gate driving signal Nout[N] is at a low potential.

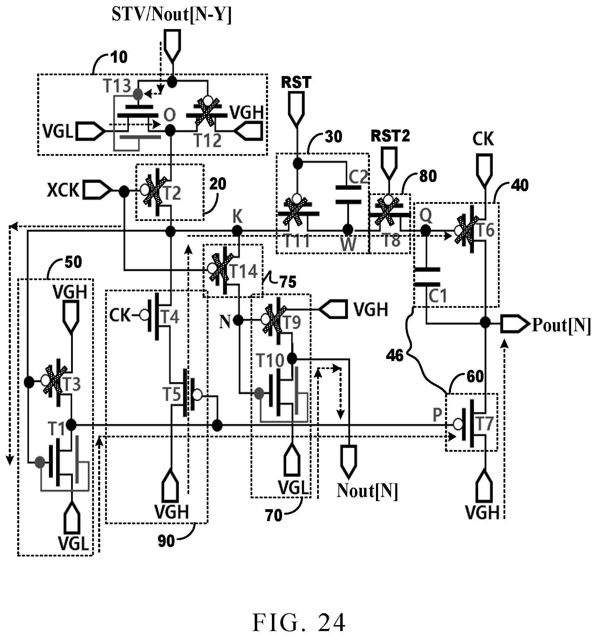

Third stage S3: As shown in FIG. 21 and FIG. 24, the second clock signal CK is at a low potential; the start control signal STV and the first clock signal XCK are at a high potential; the node N is at a high potential; the fourth node P is at a low potential; and the N^{th}-stage positive-pulse gate driving signal Nout[N] is at a low potential.

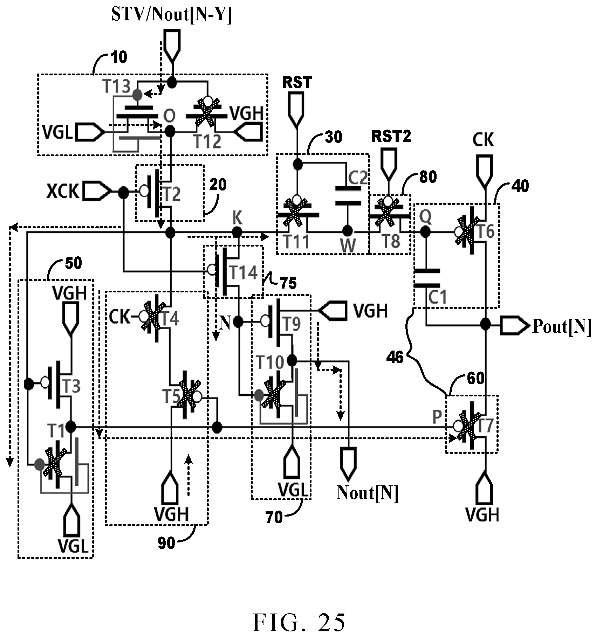

Fourth stage S4: As shown in FIG. 21 and FIG. 25, the first clock signal XCK is at a low potential; the start control signal STV and the second clock signal CK are at a high potential; the fourth node P is at a high potential; the node N is at a low potential; and the N^{th}-stage positive-pulse gate driving signal Nout[N] is at a high potential.

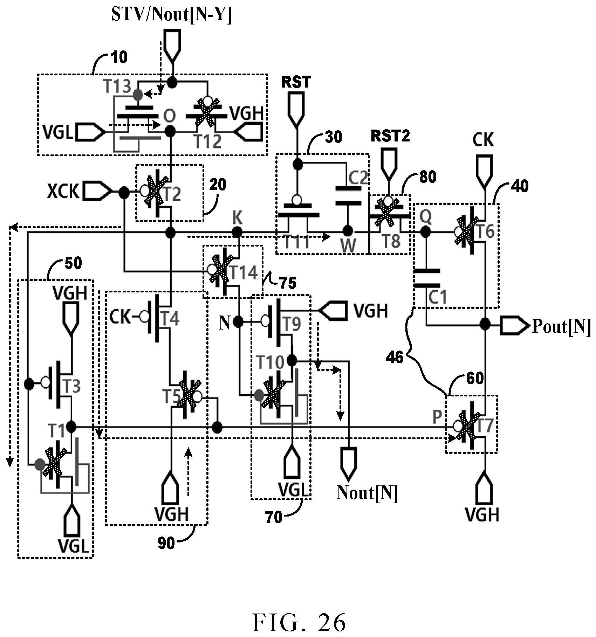

Fifth stage S5: As shown in FIG. 21 and FIG. 26, the second clock signal CK is at a low potential; the start control signal STV and the first clock signal XCK are at a high potential; the fourth node P is at a high potential; the node N is at a low potential; and the N^{th}-stage positive-pulse gate driving signal Nout[N] is at a high potential.

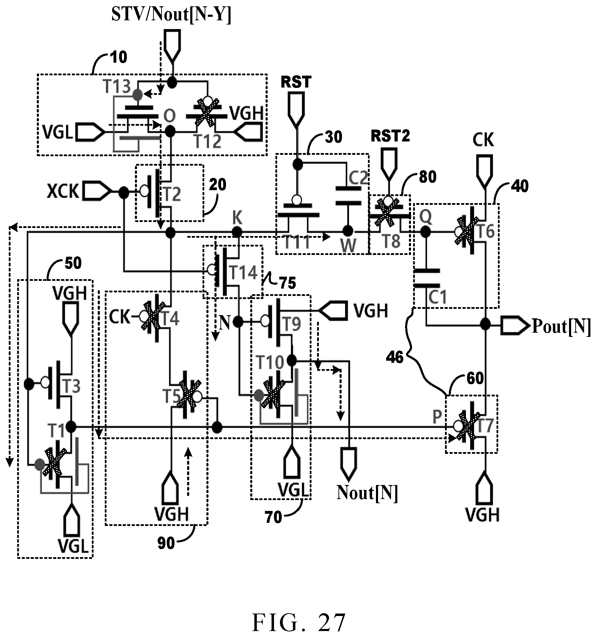

Sixth stage S6: As shown in FIG. 21 and FIG. 27, the first clock signal XCK is at a low potential; the start control signal STV and the second clock signal CK are at a high potential; the fourth node P is at a high potential; the node N is at a low potential; and the N^{th}-stage positive-pulse gate driving signal Nout[N] is at a high potential.

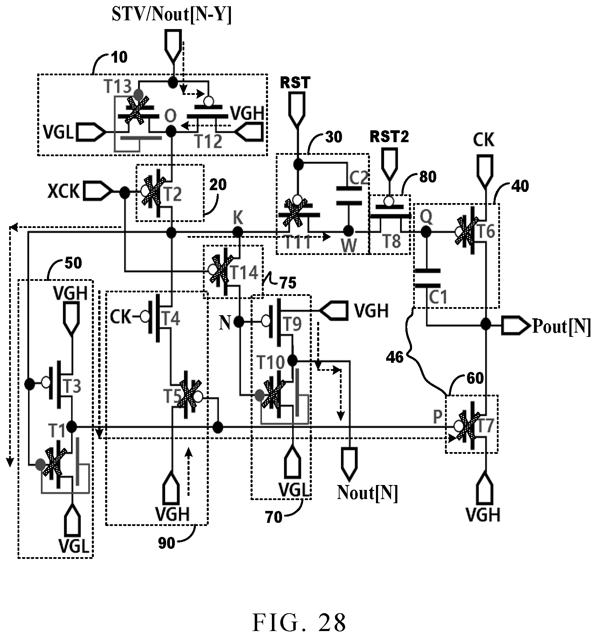

Seventh stage S7: As shown in FIG. 21 and FIG. 28, the start control signal STV and the second clock signal CK are at a low potential; the first clock signal XCK is at a high potential; the fourth node P is at a high potential; the node N is at a low potential; and the N^{th}-stage positive-pulse gate driving signal Nout[N] is at a high potential.

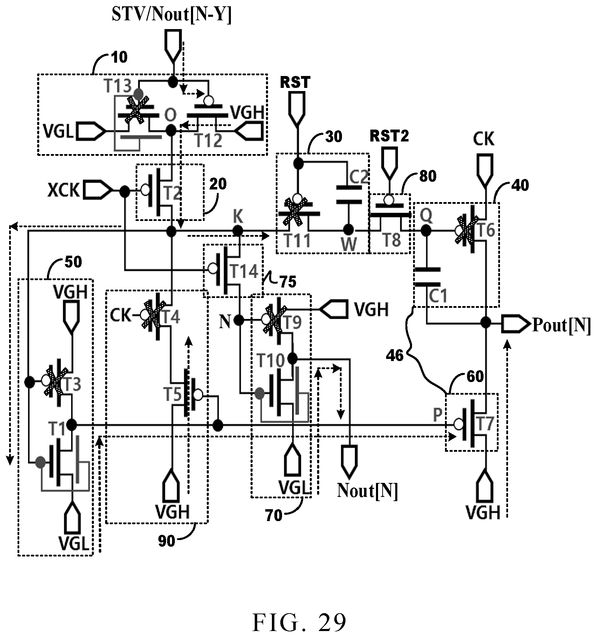

Eighth stage S8: As shown in FIG. 21 and FIG. 29, the start control signal STV and the first clock signal XCK are at a low potential; the second clock signal CK is at a high potential; the node N is at a high potential; the fourth node P is at a low potential; and the N^{th}-stage positive-pulse gate driving signal Nout[N] switches from a high potential to a low potential.

It should be noted that the "cross" in FIG. 22 to FIG. 29 indicates that the transistor covered by the "cross" is in an off state, and the transistor not covered by the "cross" is in an on state. The dashed arrows in FIG. 22 to FIG. 29 indicate the current direction.

Based on the above, FIG. 30 shows the generation process of the negative pulse of the N^{th}-stage negative-pulse gate driving signal Pout[N]. For clear description, the two pulses from right to left in the same signal are sequentially referred to as a first pulse and a second pulse. The second node K transmits the first pulse and the second pulse successively during one frame. The high potential of the former part in the two pulses of the (N-2)^{th}-stage positive-pulse gate driving signal Nout[N-2] controls the second filtering module 80 to filter out the latter part in the first pulse and the latter part in the second pulse output by the second node K; the high potential of the latter part in the first pulse of the reset signal RST controls the first filtering module 30 to filter out the former part in the second pulse output by the second node K. So far, the width of the second pulse of the node W is also narrowed; the second pulse output by the second node K is completely filtered out, and only the former part in the first pulse output by the second node K forms a negative pulse at the third node Q. The negative pulse of the third node Q turns on the pull-up module 40, so as to form a negative pulse of the N^{th}-stage negative-pulse gate driving signal Pout[N] with a fixed width.

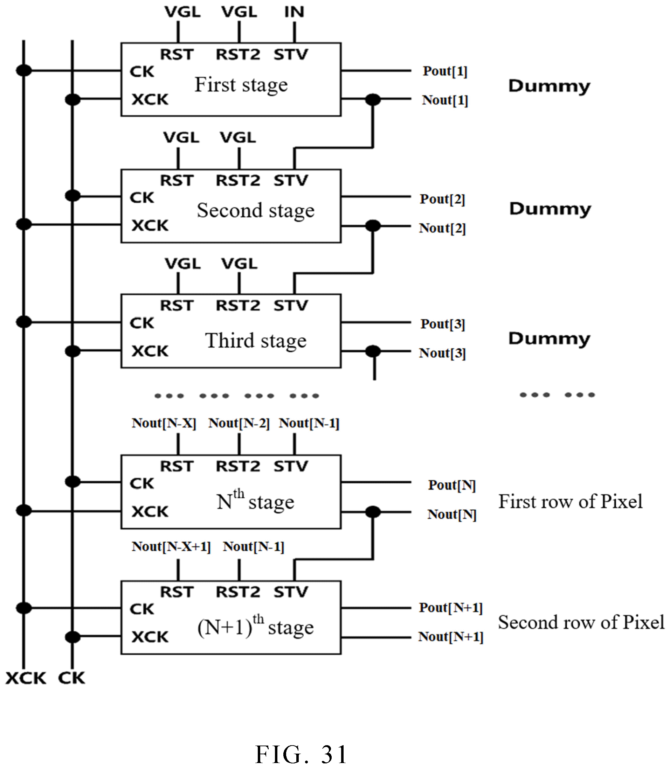

FIG. 31 is a schematic diagram of a cascaded structure between different shift registers in the gate driving circuit shown in FIG. 3 or FIG. 20, where a first-stage shift register, a second-stage shift register, a third-stage shift register,..., the N^{th}-stage shift register, an (N+1)^{th}-stage shift register,..., and so on are arranged sequentially from top to bottom. Each shift register operates according to the accessed first clock signal XCK and second clock signal CK respectively.

Where both the control terminal of the first filtering module 30 and the control terminal of the second filtering module 80 in the first-stage shift register access a low-potential signal VGL, and an input terminal (IN) of the first-stage shift register connected to the start control line accesses the start control signal STV. The first-stage shift register outputs a corresponding first-stage negative-pulse gate driving signal Pout[1] and a first-stage positive-pulse gate driving signal Nout[1]. The first-stage negative-pulse gate driving signal Pout[1] and the first-stage positive-pulse gate driving signal Nout[1] are used to drive dummy pixels (Dummy) or are floating.

Both the control terminal of the first filtering module 30 and the control terminal of the second filtering module 80 in the second-stage shift register access the low-potential signal VGL, and the start control line connected to the second-stage shift register accesses a cascaded signal, i.e., the first-stage positive-pulse gate driving signal Nout[1]. The second-stage shift register outputs a corresponding second-stage negative-pulse gate driving signal Pout[2] and a second-stage positive-pulse gate driving signal Nout[2]. The second-stage negative-pulse gate driving signal Pout[2] and the second-stage positive-pulse gate driving signal Nout[2] are used to drive dummy pixels (Dummy) or are floating.

Both the control terminal of the first filtering module 30 and the control terminal of the second filtering module 80 in the third-stage shift register access the low-potential signal VGL, and the start control line connected to the third-stage shift register accesses a cascaded signal, i.e., the second-stage positive-pulse gate driving signal Nout[2]. The third-stage shift register outputs a corresponding third-stage negative-pulse gate driving signal Pout[3] and a third-stage positive-pulse gate driving signal Nout[3]. The third-stage negative-pulse gate driving signal Pout[3] and the third-stage positive-pulse gate driving signal Nout[3] are used to drive dummy pixels (Dummy) or are floating.

The rest can be deduced by analogy until the control terminal of the first filtering module 30 and the control terminal of the second filtering module 80 in the N^{th}-stage shift register respectively access the (N-X)^{th}-stage positive-pulse gate driving signal Nout[N-X] and the (N-2)^{th-}stage positive-pulse gate driving signal Nout[N-2] in sequence, and the start control line connected to the N^{th}-stage shift register accesses a cascaded signal, i.e., the (N-1)^{th}-stage positive-pulse gate driving signal Nout[N-1]. The N^{th}-stage shift register outputs a corresponding N^{th}-stage negative-pulse gate driving signal Pout[N] and an N^{th}-stage positive-pulse gate driving signal Nout[N]. The N^{th}-stage negative-pulse gate driving signal Pout[N] and the N^{th}-stage positive-pulse gate driving signal Nout[N] are used to drive a first row of pixel circuits (Pixel).

The control terminal of the first filtering module 30 and the control terminal of the second filtering module 80 in the (N+1)^{th}-stage shift register respectively access the (N-X+1)^{th}-stage positive-pulse gate driving signal Nout[N-X+1] and the (N-1)^{th}-stage positive-pulse gate driving signal Nout[N-1] in sequence, and the start control line connected to the (N+1)^{th}-stage shift register accesses a cascaded signal, i.e., the N^{th}-stage positive-pulse gate driving signal Nout[N]. The (N+1)^{th}-stage shift register outputs a corresponding (N+1)^{th}-stage negative-pulse gate driving signal Pout[N+1] and an (N+1)^{th}-stage positive-pulse gate driving signal Nout[N+1]. The (N+1)^{th}-stage negative-pulse gate driving signal Pout[N+1] and the (N+1)^{th}-stage positive-pulse gate driving signal Nout[N+1] are used to drive a second row of pixel circuits (Pixel).

The subsequent other shift registers can be deduced by analogy. It should be noted that since the output terminals of some shift registers are connected to dummy pixels or are floating, the output terminals of the N^{th}-stage shift register are not connected to the N^{th} row of pixel circuits. Instead, the row number of the connected pixel circuits needs to be determined according to the number of shift registers that are connected to dummy pixels or are floating. For example, when the first-stage shift register to the third-stage shift register are connected to dummy pixels, then the output terminals of the N^{th}-stage shift register are connected to the (N-3)^{th} row of pixel circuits.

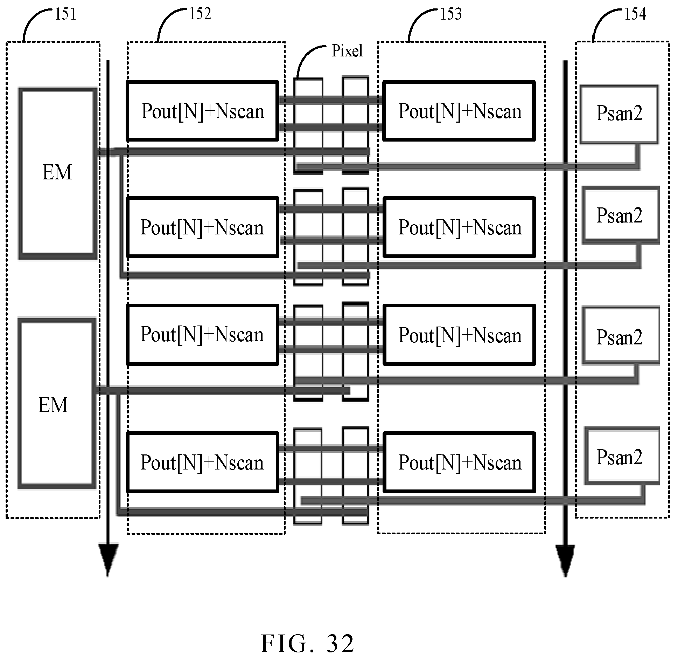

The display panel shown in FIG. 32 includes pixel circuits (Pixel) arranged in an array in a display area, a first gate driving circuit 151 configured to provide a light-emitting control signal EM, a fourth gate driving circuit 154 configured to provide a gate driving signal Pscan2, a second gate driving circuit 152 configured to provide the N^{th}-stage negative-pulse gate driving signal Pout[N] and a gate driving signal Nscan, and a third gate driving circuit 153 configured to provide the N^{th}-stage negative-pulse gate driving signal Pout[N] and the gate driving signal Nscan.

The first gate driving circuit 151 may be located on the left side of the display area. An output terminal of each shift register in the first gate driving circuit 151 provides the light-emitting control signal EM to two adjacent rows of pixel circuits through a corresponding light-emitting control line, which belongs to single-side driving.

The fourth gate driving circuit 154 may be located on the right side of the display area. An output terminal of each shift register in the fourth gate driving circuit 154 provides the gate driving signal Pscan2 to one row of pixel circuits through a corresponding gate driving line, which belongs to single-side driving.

The second gate driving circuit 152 is located between the first gate driving circuit 151 and the display area. The third gate driving circuit 153 is located between the fourth gate driving circuit 154 and the display area. A scanning line for transmitting the N^{th}-stage negative-pulse gate driving signal Pout[N] is electrically connected to an output terminal of a shift register in the second gate driving circuit 152, an output terminal of a shift register in the third gate driving circuit 153, and one row of pixel circuits. A gate driving line for transmitting the gate driving signal Nscan is electrically connected to an output terminal of a shift register in the second gate driving circuit 152, an output terminal of a shift register in the third gate driving circuit 153, and one row of pixel circuits, which belongs to double-side driving.

Both the second gate driving circuit 152 and the third gate driving circuit 153 may adopt the gate driving circuit shown in FIG. 3 or FIG. 20. The gate driving signal Nscan may include the N^{th}-stage positive-pulse gate driving signal Nout[N] and the (N-3)^{th}-stage positive-pulse gate driving signal Nout[N-3].

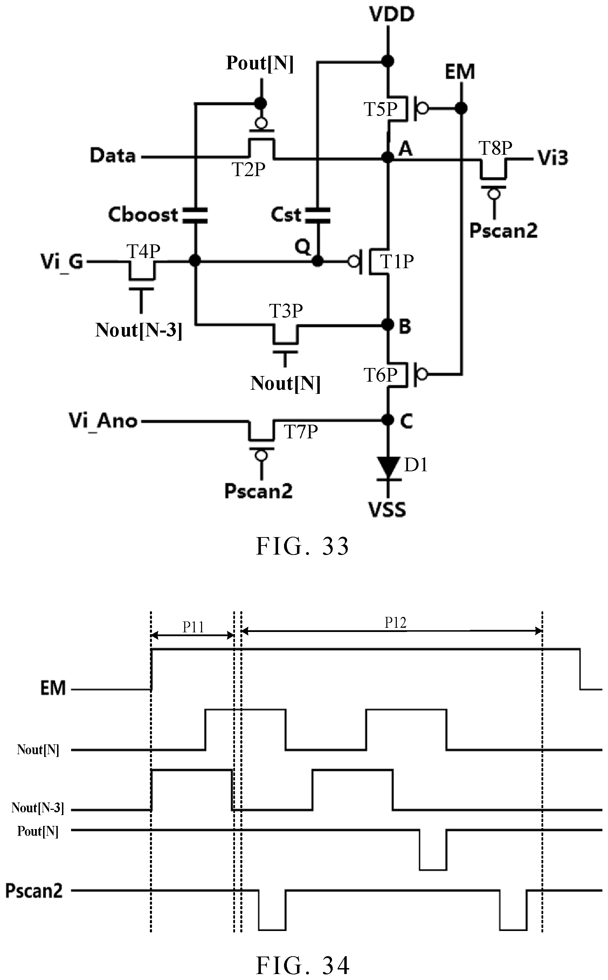

Due to the necessary reason that the gate of the first initialization transistor T4P in the pixel circuit shown in FIG. 1 accesses the (N-1)^{th}-stage positive-pulse gate driving signal Nout[N-1], after the gate of the writing transistor T2P in the pixel circuit shown in FIG. 33 accesses the N^{th}-stage negative-pulse gate driving signal Pout[N] and the gate of the compensation transistor T3P accesses the N^{th}-stage positive-pulse gate driving signal Nout[N], not only the gate of the third initialization transistor T8P can continue to use the existing gate driving signal Pscan2 (without improving the fourth gate driving circuit 154), but also the gate of the first initialization transistor T4P can be replaced to access the (N-3)^{th}-stage positive-pulse gate driving signal Nout[N-3].

After that, the pixel circuit shown in FIG. 33 can not only operate in the existing stage P12 in FIG. 34 during one frame, but also add an additional stage P11. In the stage P11, the potentials of the three terminals (Q, A, B) of the driving transistor T1P can be reset by the synchronous conduction of the first initialization transistor T4P and the compensation transistor T3P, so as to reduce the threshold voltage drift of the driving transistor T1P and improve flicker under different refresh rates.

In one embodiment, the present embodiment provides a display panel, including the gate driving circuit and the pixel circuit in at least one of the above embodiments.

It can be understood that since the display panel provided by the present embodiment includes the gate driving circuit in at least one of the above embodiments, it can also filter out the former part in the second pulse that appears later of the second node K during one frame through the first filtering module 30, and filter out the latter part in the first pulse that appears earlier and the latter part in the second pulse that appears later of the second node K during one frame through the second filtering module 80, so that the former part with a fixed width in the first pulse can be retained. Then, the first output module 46 is controlled to output a gate driving signal with a pulse of the fixed width at a corresponding time. After such improvement, the display panel can meet the driving requirements of the back-end.

It can be understood that for those of ordinary skill in the art, equivalent substitutions or changes can be made according to the technical solution of the present application and its inventive concept, and all such changes or substitutions shall fall within the protection scope of the appended claims of the present application.

## Claims

1. A gate driving circuit, comprising a plurality of cascaded shift registers, wherein an N^{th}-stage shift register comprises:
a stage-transfer signal selection module, electrically connected between a first node and a first wiring;
a pull-up control module, configured to control a potential of a second node according to a potential of the first node and a potential of a first clock signal;
a first filtering module, electrically connected between the second node and a third node, wherein a control terminal of the first filtering module is configured to access a reset signal;
a second filtering module, electrically connected between the first filtering module and the third node, wherein a control terminal of the second filtering module is configured to access a filtering control signal having a plurality of pulses during one frame; and
a first output module, configured to output a first gate driving signal according to a potential of the third node and a potential of a fourth node.

2. The gate driving circuit according to claim 1, wherein the N^{th}-stage shift register further comprises:
a first inverting module, electrically connected between the second node and the fourth node; and
a second output module, configured to output a second gate driving signal according to the potential of the second node;
wherein a frequency of the second gate driving signal is the same as a frequency of the filtering control signal, and a phase of the second gate driving signal is different from a phase of the filtering control signal.

3. The gate driving circuit according to claim 2, wherein the frequency of the second gate driving signal is the same as a frequency of the reset signal, and the phase of the second gate driving signal is different from a phase of the reset signal.

4. The gate driving circuit according to claim 1, wherein the first filtering module comprises:
a first filtering transistor, wherein one of a source and a drain of the first filtering transistor is electrically connected to the second node, another of the source and the drain of the first filtering transistor is electrically connected to the third node, and a gate of the first filtering transistor is configured to access the reset signal; and
a first capacitor, wherein one end of the first capacitor is electrically connected to the gate of the first filtering transistor, and another end of the first capacitor is electrically connected to another of the source and the drain of the first filtering transistor.

5. The gate driving circuit according to claim 1, wherein the second filtering module comprises a second filtering transistor, one of a source and a drain of the second filtering transistor is electrically connected to the first filtering module, another of the source and the drain of the second filtering transistor is electrically connected to the third node, and a gate of the second filtering transistor is configured to access the filtering control signal.

6. The gate driving circuit according to claim 1, wherein the N^{th}-stage shift register further comprises an isolation module, connected in series between the second node and an input terminal of the second output module, wherein a control terminal of the isolation module is configured to access the first clock signal.

7. The gate driving circuit according to claim 6, wherein the isolation module comprises an isolation transistor, one of a source and a drain of the isolation transistor is electrically connected to the second node, another of the source and the drain of the isolation transistor is electrically connected to the input terminal of the second output module, a gate of the isolation transistor is configured to access the first clock signal, and the isolation transistor is a P-channel thin film transistor.

8. The gate driving circuit according to claim 6, wherein the isolation module is configured to reduce coupling of a pulse amplitude of the first gate driving signal to a pulse amplitude of the second gate driving signal.

9. The gate driving circuit according to claim 1, wherein the second node is configured to transmit a first pulse and a second pulse successively during one frame; and the first filtering module is configured to filter out a former part in the second pulse.

10. The gate driving circuit according to claim 1, wherein the second node is configured to transmit a first pulse and a second pulse successively during one frame; and the second filtering module is configured to filter out a latter part in the first pulse and a latter part in the second pulse.

11. The gate driving circuit according to claim 1, wherein the second node is configured to transmit a first pulse and a second pulse successively during one frame; and the first filtering module and the second filtering module are configured to filter out the second pulse and retain a former part with a fixed width in the first pulse.

12. A display panel, comprising:
a pixel circuit, comprising a writing transistor configured to control input of a data signal, and a compensation transistor configured to control input of the data signal to a gate of a driving transistor; and
the gate driving circuit according to claim 1, wherein an output terminal of the first output module is electrically connected to a gate of the writing transistor, and an output terminal of the second output module is electrically connected to a gate of the compensation transistor.

13. The display panel according to claim 12, wherein the N^{th}-stage shift register further comprises:
a first inverting module, electrically connected between the second node and the fourth node;
a second output module, configured to output a second gate driving signal according to a potential of the second node;
wherein a frequency of the second gate driving signal is the same as a frequency of the filtering control signal, and a phase of the second gate driving signal is different from a phase of the filtering control signal.

14. The display panel according to claim 13, wherein a frequency of the second gate driving signal is the same as a frequency of the reset signal, and a phase of the second gate driving signal is different from a phase of the reset signal.

15. The display panel according to claim 12, wherein the first filtering module comprises:
a first filtering transistor, wherein one of a source and a drain of the first filtering transistor is electrically connected to the second node, another of the source and the drain of the first filtering transistor is electrically connected to the third node, and a gate of the first filtering transistor is configured to access the reset signal; and
a first capacitor, wherein one end of the first capacitor is electrically connected to the gate of the first filtering transistor, and another end of the first capacitor is electrically connected to another of the source and the drain of the first filtering transistor.

16. The display panel according to claim 12, wherein the second filtering module comprises a second filtering transistor, wherein one of a source and a drain of the second filtering transistor is electrically connected to the first filtering module, another of the source and the drain of the second filtering transistor is electrically connected to the third node, and a gate of the second filtering transistor is configured to access the filtering control signal.

17. The display panel according to claim 12, wherein the N^{th}-stage shift register further comprises an isolation module, connected in series between the second node and an input terminal of the second output module, and a control terminal of the isolation module is configured to access the first clock signal.

18. The display panel according to claim 17, wherein the isolation module comprises an isolation transistor, one of a source and a drain of the isolation transistor is electrically connected to the second node, another of the source and the drain of the isolation transistor is electrically connected to the input terminal of the second output module, a gate of the isolation transistor is configured to access the first clock signal, and the isolation transistor is a P-channel thin film transistor.

19. The display panel according to claim 17, wherein the isolation module is configured to reduce coupling of a pulse amplitude of the first gate driving signal to a pulse amplitude of the second gate driving signal.

20. The display panel according to claim 12, wherein the second node is configured to transmit a first pulse and a second pulse successively during one frame; and the first filtering module is configured to filter out a former part in the second pulse.
